# EUROPEAN PATENT APPLICATION

(11) **EP 4 704 154 A1**
(43) Date of publication of application: **04.03.2026**
(21) Application number: 23935386.5
(22) Date of filing: 28.04.2023
(51) Int. Cl.: H01L 27/146

(54) **LIGHT DETECTION DEVICE**

(71) Applicant: Sony Semiconductor Solutions Corporation, Atsugi-shi, Kanagawa 243-0014 (JP)
(72) Inventor: FUJISAKI, Yutaro, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/016899
(87) International publication number: WO 2024/224610

(57) **Abstract**

A photodetector includes a first base, a second base, and a light blocker. The first base includes a first semiconductor substrate in which a first photoelectric conversion element is disposed. The first photoelectric conversion element converts entering light into electric charge. The second base is disposed on an opposite side of the first base to a light entering side and includes a second semiconductor substrate in which a second photoelectric conversion element is disposed. The second photoelectric conversion element converts entering light into electric charge. The light blocker is disposed, as viewed from the light entering side, along and around a side surface of the second photoelectric conversion element. The light blocker extends from a surface of the second base on the light entering side through at least the second semiconductor substrate in a thickness direction. The light blocker blocks light from the second photoelectric conversion element.

## Description

### Technical Field

The present disclosure relates to a photodetector.

### Background Art

PTL 1 discloses a solid-state imaging device. The solid-state imaging device includes a structure in which a first photoelectric conversion layer, a second photoelectric conversion layer, and a third photoelectric conversion layer are stacked in order from a light entering side. A first isolator is disposed around the first photoelectric conversion layer. Similarly, a second isolator is disposed around the second photoelectric conversion layer, and a third separator is disposed around the third photoelectric conversion layer.
The solid-state imaging device having such a configuration makes it possible to perform color separation of light for each of the stacked photoelectric conversion layers.

### Citation List

### Patent Literature

PTL 1: Japanese Unexamined Patent Application Publication No. 2014-232761

### Summary of the Invention

In the above-described solid-state imaging device, the isolator is disposed in a region corresponding to a side surface of the photoelectric conversion layer. However, between each of stacking interfaces of the photoelectric conversion layers and the isolator, a path causing light leakage is present between the photoelectric conversion layers that are disposed to be adjacent to each other in a plane direction. For example, the second isolator is disposed between the second photoelectric conversion layers disposed to be adjacent to each other in the plane direction. A path inducing light leakage is present between a stacking interface of a layer in which the first photoelectric conversion layer is disposed, and the second isolator.

Accordingly, it has been desired to develop a photodetector that makes it possible to effectively suppress or prevent color mixing between photoelectric conversion layers that are disposed to be adjacent to each other.

A photodetector according to a first embodiment of the present disclosure includes a first base, a second base, and a light blocker. The first base includes a first semiconductor substrate in which a first photoelectric conversion element is disposed. The first photoelectric conversion element converts entering light into electric charge. The second base is disposed on an opposite side of the first base to a light entering side and includes a second semiconductor substrate in which a second photoelectric conversion element is disposed. The second photoelectric conversion element converts entering light into electric charge. The light blocker is disposed, as viewed from the light entering side, along and around a side surface of the second photoelectric conversion element. The light blocker extends from a surface of the second base on the light entering side through at least the second semiconductor substrate in a thickness direction. The light blocker blocks light from the second photoelectric conversion element.

In the photodetector according to a second embodiment of the present disclosure, the first photoelectric conversion element in the photodetector according to the first embodiment includes a photodiode. In addition, the second photoelectric conversion element includes an avalanche diode that multiplies a carrier generated by a photon of entering light.

The photodetector according to a third embodiment of the present disclosure further includes, in the photodetector according to the first embodiment or the second embodiment, a third base disposed on an opposite side of the second base to the first base and including a third semiconductor substrate on which a circuit is mounted. The circuit is electrically coupled to the first photoelectric conversion element, the second photoelectric conversion element, or both.

### Brief Description of the Drawings

[FIG. 1] FIG. 1 is a vertical cross-sectional configuration diagram of a main part of a photodetector according to a first embodiment of the present disclosure.
[FIG. 2] FIG. 2 is a plan configuration diagram (a plan configuration diagram taken along section line A-A illustrated in FIG. 1) of the main part of the photodetector illustrated in FIG. 1.
[FIG. 3] FIG. 3 is a plan configuration diagram (a plan configuration diagram taken along section line B-B illustrated in FIG. 1) of the main part of the photodetector illustrated in FIG. 1.
[FIG. 4] FIG. 4 is a circuit diagram illustrating a first photoelectric conversion element and a readout circuit thereof in the photodetector illustrated in FIG. 1.
[FIG. 5] FIG. 5 is a circuit diagram illustrating a second photoelectric conversion element and a readout circuit thereof in the photodetector illustrated in FIG. 1.
[FIG. 6] FIG. 6 is a first process cross-sectional diagram corresponding to FIG. 1 and describing, process by process, a manufacturing method of the photodetector according to the first embodiment.
[FIG. 7] FIG. 7 is a second process cross-sectional diagram.
[FIG. 8] FIG. 8 is a third process cross-sectional diagram.
[FIG. 9] FIG. 9 is a fourth process cross-sectional diagram.
[FIG. 10] FIG. 10 is a fifth process cross-sectional diagram.
[FIG. 11] FIG. 11 is a sixth process cross-sectional diagram.
[FIG. 12] FIG. 12 is a vertical cross-sectional configuration diagram of a main part of a photodetector according to a second embodiment of the present disclosure, and corresponds to FIG. 1.
[FIG. 13] FIG. 13 is a vertical cross-sectional configuration diagram of a main part of a photodetector according to a third embodiment of the present disclosure, and corresponds to FIG. 1.
[FIG. 14] FIG. 14 is a plan configuration diagram (a plan configuration diagram taken along section line C-C illustrated in FIG. 13) of the main part of the photodetector illustrated in FIG. 13, and corresponds to FIG. 3.
[FIG. 15] FIG. 15 is a plan configuration diagram of a main part of a photodetector according to a modification example of the third embodiment, and corresponds to FIG. 14.
[FIG. 16] FIG. 16 is a vertical cross-sectional configuration diagram of a main part of a photodetector according to a fourth embodiment of the present disclosure, and corresponds to FIG. 1.
[FIG. 17] FIG. 17 is a vertical cross-sectional configuration diagram of a main part of a photodetector according to a fifth embodiment of the present disclosure, and corresponds to FIG. 1.
[FIG. 18] FIG. 18 is a vertical cross-sectional configuration diagram of a main part of a photodetector according to a sixth embodiment of the present disclosure, and corresponds to FIG. 1.
[FIG. 19] FIG. 19 is a vertical cross-sectional configuration diagram of a main part of a photodetector according to a seventh embodiment of the present disclosure, and corresponds to FIG. 1.
[FIG. 20] FIG. 20 is a block diagram depicting an example of schematic configuration of a vehicle control system.
[FIG. 21] FIG. 21 is a diagram of assistance in explaining an example of installation positions of an outside-vehicle information detecting section and an imaging section.

### Modes for Carrying Out the Invention

Hereinafter, embodiments of the present disclosure will be described in detail with reference to the drawings. It is to be noted that the description will be given in the following order.

### 1. First Embodiment

A first embodiment is a first example in which the present technology is applied to a photodetector. In the first embodiment, a description will be given of a configuration of a pixel, a configuration of a circuit, and a manufacturing method of the photodetector. In particular, in the first embodiment, a description will be given of a configuration of a photoelectric conversion element, a configuration of a light blocker, and a manufacturing method thereof.

### 2. Second Embodiment

A second embodiment is a second example in which the configuration of the light blocker is changed in a solid-state imaging device according to the first embodiment.

### 3. Third Embodiment

A third embodiment is a third example in which the configuration of the light blocker is changed in a solid-state imaging device according to the second embodiment.

### 4. Fourth Embodiment

A fourth embodiment is a fourth example in which a coupling configuration of the light blocker is changed in a solid-state imaging device according to the third embodiment.

### 5. Fifth Embodiment

A fifth embodiment is a fifth example in which the configuration of the light blocker is changed in a solid-state imaging device according to the fourth embodiment.

### 6. Sixth Embodiment

A sixth embodiment is a sixth example in which the configuration of the light blocker is changed in the solid-state imaging device according to the first embodiment.

### 7. Seventh Embodiment

A seventh embodiment is a seventh example in which the configuration of the light blocker is changed in the solid-state imaging device according to the first embodiment.

### 8. Example of Application to Mobile Body

This application example describes an example in which the present technology is applied to a vehicle control system that is an example of a mobile body control system.

### 9. Other Embodiments

### <1. First Embodiment>

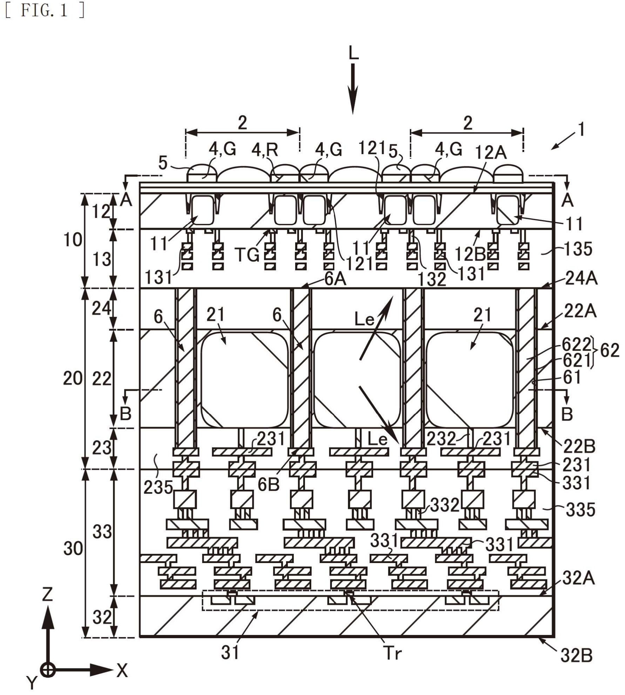

A photodetector 1 according to the first embodiment of the present disclosure will be described with reference to FIGs. 1 to 11.

Here, in the drawings, on an as-needed basis, an arrow X direction illustrated indicates one plane direction of the photodetector 1 placed on a plane for convenience. An arrow Y direction indicates another plane direction orthogonal to the arrow X direction. In addition, an arrow Z direction indicates an up direction orthogonal to the arrow X direction and the arrow Y direction. That is, the arrow X direction, the arrow Y direction, and the arrow Z direction just coincide with an X axis direction, a Y axis direction, and Z axis direction of the three-dimensional coordinate system, respectively. In addition, an opposite direction to the arrow Z direction is an entering direction of entering light L.

It is to be noted that each of these directions is indicated for easier understanding of the description and does not limit the directions in the present technology.

### [Configuration of Photodetector 1]

### (1) Circuit Configuration of Photodetector 1

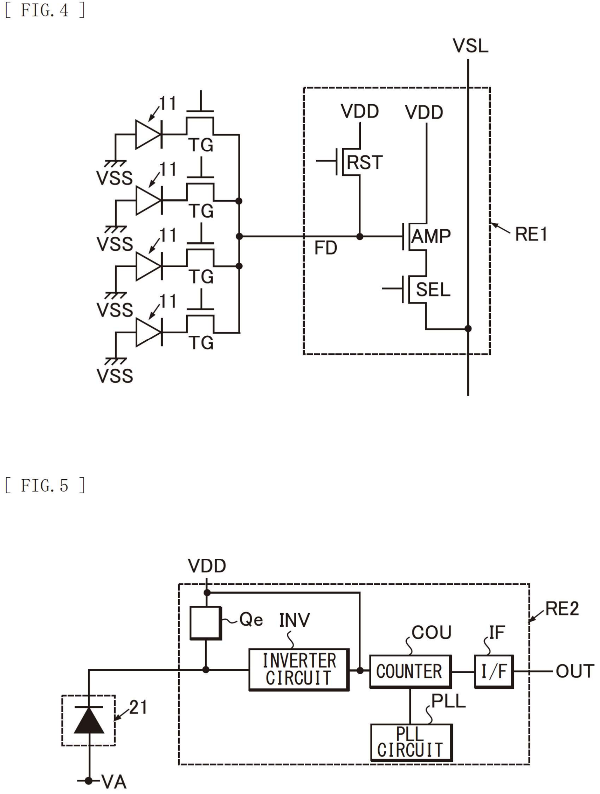

FIG. 4 illustrates an example of a circuit configuration of a first photoelectric conversion element 11 and a first readout circuit RE1 thereof in the photodetector 1 according to the first embodiment. FIG. 5 illustrates an example of a circuit configuration of a second photoelectric conversion element 21 and a second readout circuit RE2 thereof in the photodetector 1.

As illustrated in FIGs. 4 and 5, the photodetector 1 according to the first embodiment includes two kinds of photoelectric conversion elements, i.e., the first photoelectric conversion element 11 and the second photoelectric conversion element 21. The two kinds of photoelectric conversion elements, i.e., the first photoelectric conversion element 11 and the second photoelectric conversion element 21 form a pixel 2 (see FIG. 1).

As illustrated in FIG. 4, the first photoelectric conversion element 11 is electrically coupled to the first readout circuit RE1. Meanwhile, as illustrated in FIG. 5, the second photoelectric conversion element 21 is electrically coupled to the second readout circuit RE2.

This will be described in detail below.

### (1-1) Circuit Configuration of First Photoelectric Conversion Element 11 and First Readout Circuit RE1

As illustrated in FIG. 4, the first photoelectric conversion element 11 includes a photodiode (Photo Diode). The photodiode is formed at a pn junction part between an anode region and a cathode region. The first photoelectric conversion element 11 converts the entering light L (see FIG. 1) into electric charge (an electric signal). Here, the first photoelectric conversion element 11 converts visible light into electric charge. The visible light includes a red light band, a green light band, and a blue light band.

The anode region of the first photoelectric conversion element 11 is electrically coupled to a fixed power supply. Here, the anode region is coupled to, for example, a grounded power supply VSS.

The cathode region is electrically coupled to a floating diffusion FD via a transfer transistor TG. The floating diffusion FD is electrically coupled to the first readout circuit RE1.

One of a pair of main electrodes of the transfer transistor TG is electrically coupled to the first photoelectric conversion element 11. Another of the main electrodes is electrically coupled to the floating diffusion FD. A gate electrode receives a transfer signal.

In the first embodiment, one first readout circuit RE1 is disposed, as a pixel circuit, for four first photoelectric conversion elements 11 and four transfer transistors TG. The first readout circuit RE1 is configured to read out electric charge converted from light at the first photoelectric conversion element 11.

The first readout circuit RE1 includes at least a reset transistor RST, an amplification transistor AMD, and a selection transistor SEL. In addition, the first readout circuit RE1 may further include a floating diffusion conversion gain switching transistor, which is not illustrated.

One of a pair of main electrodes of the reset transistor RST is electrically coupled to the floating diffusion FD. Another of the main electrodes is electrically coupled to a power supply voltage VDD. A gate electrode receives a reset signal.

One of a pair of main electrodes of the amplification transistor AMP is electrically coupled to the power supply voltage VDD. Another of the main electrodes is electrically coupled to one of a pair of main electrodes of the selection transistor SEL. The floating diffusion FD is electrically coupled to a gate electrode.

Another of the main electrodes of the selection transistor SEL is electrically coupled to an output signal line (a vertical signal line) VSL. A gate electrode receives a selection signal.

Here, an insulated gate field effect transistor (IGFET: Insulated Gate Field Effect Transistor) is used for each of the transistors including, without limitation, the transfer transistor TG, the reset transistor RST of the first readout circuit RE1, and the like described above. As used herein, the term IGFET includes a MOSFET (Metal Oxide Semiconductor Field Effect Transistor) and a MISFET (Metal Insulator Semiconductor Field Effect Transistor).

In the photodetector 1, the first readout circuit RE1 is further coupled to an image processing circuit, which is not illustrated. The image processing circuit includes, for example, an analog to digital converter (ADC) and a digital signal processor (DSP).

The electric charge converted from light by the first photoelectric conversion element 11 is an analog signal. The analog signal is subjected to an amplification process at the first readout circuit RE1. The ADC converts the analog signal outputted from the first readout circuit RE1 into a digital signal. The DSP performs functional processing on the digital signal. That is, the image processing circuit performs signal processing for image generation.

It is to be noted that one first readout circuit RE1 may be disposed for one, two, or eight first photoelectric conversion elements 11 and one, two, or eight transfer transistors TG.

Here, the "first readout circuit RE1" or the unillustrated "image processing circuit" corresponds to a "circuit" electrically coupled to the first photoelectric conversion element 11 according to the present technology.

### (1-2) Circuit Configuration of Second Photoelectric Conversion Element 21 and Second Readout Circuit RE2

As illustrated in FIG. 5, here, the second photoelectric conversion element 21 includes a single photon avalanche diode (hereinafter, simply referred to as an "SPAD (Single Photon Avalanche Diode)"). The SPAD includes a multiplication region in which carriers generated by photons of the entering light L are multiplied. In the first embodiment, the second photoelectric conversion element 21 generates carriers from photons of infrared light. In addition, the SPAD is formed at a pn junction part between the anode region and the cathode region.

It is to be noted that the second photoelectric conversion element 21 is not limited to the infrared light, and may generate carriers from photons of visible light. These carriers may be used in imaging.

The anode region of the SPAD receives an anode voltage VA. The anode voltage VA is a large negative voltage that allows for avalanche multiplication. In other words, the anode voltage VA is a voltage that is higher than or equal to a breakdown voltage. The anode voltage VA is, for example, a voltage of -20 V.

Instead of the SPAD, the second photoelectric conversion element 21 may be configured to include an avalanche photodiode (APD: Avalanche Photo Diode), a silicon photomultiplier (SiPM: Silicon Photomultiplier), or the like that operates in a non-linear region. Alternatively, the second photoelectric conversion element 21 may include a photodiode, as with the first photoelectric conversion element 11.

The second photoelectric conversion element 21 is electrically coupled to the second readout circuit RE2. That is, the cathode region of the SPAD is coupled to the second readout circuit RE2. For example, 1 V to be clamped on the second readout circuit RE2 side is applied to the cathode region of the second photoelectric conversion element 21.

Here, the second readout circuit RE2 includes a quench (Quench) element Qe, an inverter INV, a counter COU, a phase locked loop (Phase Locked Loop) PLL, and an interface circuit IF. Here, the quench element Qe draws out an avalanche current and resets the second readout circuit RE2.

It is to be noted that the second photoelectric conversion element 21 may be coupled to the second readout circuit RE2 via an unillustrated protective circuit.

In addition, the interface circuit IF is configured to be electrically coupled to, for example, an unillustrated time measurement circuit. The photodetector 1 may form a ranging system including the time measurement circuit.

Here, the "second readout circuit RE2" or the unillustrated "time measurement circuit" corresponds to a "circuit" electrically coupled to the second photoelectric conversion element 21 according to the present technology.

### (2) Overall Configuration of Photodetector 1

Next, a specific device configuration of the photodetector 1 will be described.

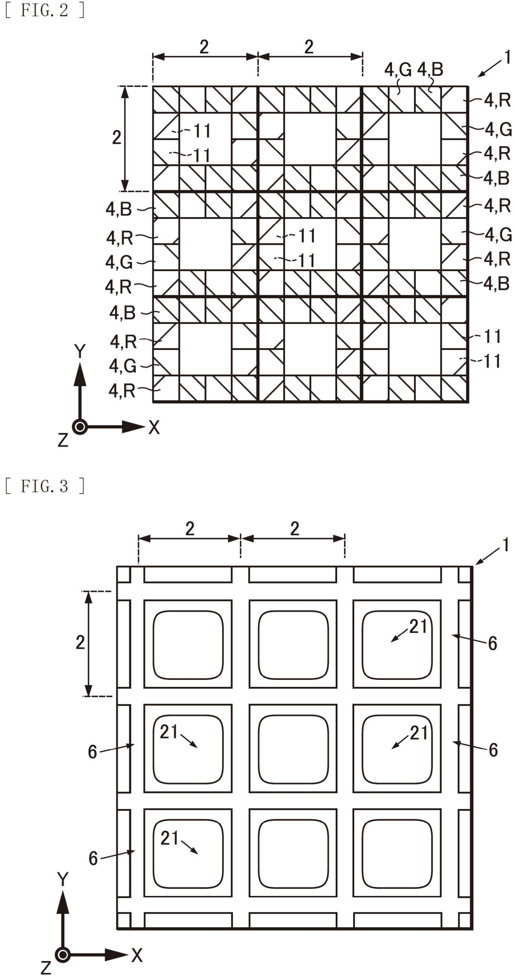

FIG. 1 illustrates an example of a vertical cross-sectional configuration corresponding to multiple pixels 2 of the photodetector 1. FIG. 2 illustrates an example of a plan configuration of the multiple pixels 2 and optical filters 4 disposed in the pixels 2 of the photodetector 1. FIG. 3 illustrates an example of a plan configuration of the second photoelectric conversion element 21 and a light blocker 6 of the photodetector 1.

As illustrated in FIG. 1, the photodetector 1 according to the first embodiment includes a first base 10, a second base 20, and a third base 30, and is configured to have a three-layered base structure. The first base 10, the second base 20, and the third base 30 are stacked in order in a direction opposite to the arrow Z direction. Here, the direction opposite to the arrow Z direction and the light entering direction L coincide with each other. Therefore, in other words, the first base 10, the second base 20, and the third base 30 are disposed in order in the entering direction of the entering light L.

The first base 10 includes a first semiconductor substrate 12 in which the first photoelectric conversion element 11 is disposed. The second base 20 includes a second semiconductor substrate 22 in which the second photoelectric conversion element 21 is disposed. In addition, the third base 30 includes a third semiconductor substrate 32 in which a circuit 31 is disposed. The circuit 31 includes one or more selected from the first readout circuit RE1, the image processing circuit, the second readout circuit RE2, and the time measurement circuit.

It is to be noted that, in the present technology, the photodetector 1 may be configured to have a two-layered base structure including the first base 10 and the second base 20. Alternatively, the photodetector 1 may include a fourth substrate or more, and may be configured to have a base structure including four or more layers.

### (3) Configuration of First Base 10 and First Photoelectric Conversion Element 11

The first base 10 includes the first semiconductor substrate 12 and a first wiring layer 13 disposed on a surface 12B of the first semiconductor substrate 12 on an opposite side to the arrow Z direction.

In the first embodiment, a single-crystal silicon (Si) substrate is used for the first semiconductor substrate 12. More specifically, the single-crystal Si substrate includes a semiconductor region of an n-type as a first conductivity type and a semiconductor region of a p-type as a second conductivity type in a predetermined region. Here, the predetermined region is, for example, a region in which the first photoelectric conversion element 11 is disposed. That is, although not illustrated and described in detail structure, the first photoelectric conversion element 11 is configured to include a photodiode having the p-type semiconductor region as the anode region and the n-type semiconductor region as the cathode region in the first semiconductor substrate 12.

Further, as the first semiconductor substrate 12, one or more substrates selected from crystal Si, amorphous Si, microcrystalline Si, crystal selenium, amorphous selenium, and chalcopyrite-based compounds may be used. The chalcopyrite-based compounds include CIGS (CuInGaSe), CIS (CuInSe₂), CuInS₂, CuAlS₂, CuAlSe₂, CuGaS₂, CuGaSe₂, AgAlS₂, AgAlSe₂, AgInS₂, and AgInSe₂.

In addition, as the first semiconductor substrate 12, one or more compound semiconductor substrates selected from GaAs, InP, AlGaAs, InGaP, AlGaInP, InGaAsP, CdSe, CdS, In₂Se₃, In₂S₃, Bi₂Se₃, Bi₂S₃, ZnSe, ZnS, PbSe, and PbS, which are group III-V compound semiconductors, may be used.

In the first wiring layer 13, multiple layers of wirings 131 and a plug wiring 132 that electrically couples the element and the wiring 131 are disposed. Here, the transfer transistor TG is illustrated in a simplified manner as the element.

For the wiring 131, for example, a wiring material such as Cu or a transparent electrode material such as IZO (Indium Zinc Oxide) or ITO (Indium Tin Oxide) is used. For example, a wiring material such as W is used for the plug wiring 132.

Each of the wiring 131 and the plug wiring 132 is embedded in an insulating layer 135. In actuality, the insulating layer 135 is formed by stacking multiple layers of insulating films. As the insulating films, for example, SiO₂ is used.

### (4) Configuration of Pixel 2

Here, a plan shape of one pixel 2 is formed in a rectangular shape when viewed from the entering direction of the entering light L (hereinafter, simply described as "in a plan view"). Here, the plan shape of the pixel 2 is formed in a square shape. Although not illustrated in detail, a plan shape of the first photoelectric conversion element 11 is formed in a rectangular shape as with the plan shape of the pixel 2, and is formed in a similar shape smaller than the plan shape of the pixel 2.

In one pixel 2, multiple first photoelectric conversion elements 11 are disposed. More specifically, in the first embodiment, a total of twelve first photoelectric conversion elements 11 are regularly disposed in a peripheral part along each side of one pixel 2. That is, four first photoelectric conversion elements 11 are disposed in a row in the arrow Y direction on each of the sides of the pixel 2 facing each other in the arrow X direction. Meanwhile, two first photoelectric conversion elements 11 are disposed in a row in the arrow X direction on each of the sides of the pixel 2 facing each other in the arrow Y direction.

The first photoelectric conversion element 11 is not disposed in a middle part of the pixel 2. This region is formed as an entering path of the entering light L into the second photoelectric conversion element 21.

A pixel isolator 121 is disposed between the first photoelectric conversion elements 11 adjacent to each other in the arrow X direction and the arrow Y direction. Although the detailed structure and the description thereof are omitted, for example, the pixel isolator 121 has a groove and includes a buried member. The groove is formed, in a thickness direction of the first semiconductor substrate 12, from a surface 12A of the first semiconductor substrate 12 in the arrow Z direction, for example. The buried member is buried in the groove.

It suffices that the groove of the pixel isolator 121 electrically and optically isolates the adjacent first photoelectric conversion elements 11 from each other, regardless of whether or not the groove extends through the first semiconductor substrate 12. In addition, as with the groove, it suffices that the buried member electrically and optically isolates the adjacent first photoelectric conversion elements 11 from each other. As the buried member, for example, SiO₂, which is an insulating material, may be practically used.

It is to be noted that the arrangement pattern of the first photoelectric conversion elements 11 described in the first embodiment is merely an example.

For example, in the present technology, in one pixel 2, three photoelectric conversion elements 11 may be disposed in the arrow X direction and three photoelectric conversion elements 11 may be disposed in the arrow Y direction, corresponding to a red wavelength range, a green wavelength range, and a blue wavelength range (hereinafter, simply referred to as "RGB"). Alternatively, in one pixel 2, one photoelectric conversion element 11 may be disposed in the arrow X direction and one photoelectric conversion element 11 may be disposed in the arrow Y direction in a similar manner. Alternatively, in one pixel 2, two photoelectric conversion elements 11 may be disposed in the arrow X direction and two photoelectric conversion elements 11 may be disposed in the arrow Y direction in a similar manner.

In addition, in the present technology, the second photoelectric conversion element 21 may be disposed not at the middle part of the pixel 2 but at a peripheral part thereof.

### (5) Configuration of Optical Filter 4

As illustrated FIGs. 1 and 2, the optical filter 4 is disposed in the arrow Z direction of the first photoelectric conversion element 11 with a protective film, whose reference sign is omitted, interposed therebetween. In other words, the optical filter 4 is disposed on the surface 12A of the first semiconductor substrate 12 with the protective film interposed therebetween. The optical filter 4 is disposed for each of the first photoelectric conversion elements 11.

A plan shape of the optical filter 4 is formed in a rectangular shape, as with the plan shape of the first photoelectric conversion element 11. In addition, a plan size of the optical filter 4 is substantially the same as a plan size of the first photoelectric conversion element 11.

In the first embodiment, the first photoelectric conversion element 11 is configured to perform photoelectric conversion on light in a visible light band. Therefore, in one pixel 2, three kinds of optical filters 4 are disposed. The three kinds of optical filters 4 are the optical filter 4 that transmits light in the red wavelength range, the optical filter 4 that transmits light in the blue wavelength range, and the optical filter 4 that transmits light in the green wavelength range. In the drawings, the optical filter 4 that transmits the light in the red wavelength range is denoted by a reference sign "R". Similarly, the optical filter 4 that transmits the light in the blue wavelength range is denoted by a reference sign "B", and the optical filter 4 that transmits the light in the green wavelength range is denoted by a reference sign "G".

In one pixel 2, four optical filters 4 denoted by the reference sign R, four optical filters 4 denoted by the reference sign B, and four optical filters 4 denoted by the reference sign G are alternately arranged in an appropriate manner.

Here, the four first photoelectric conversion elements 11 on which the four respective optical filters 4 denoted by the same reference sign are provided are coupled to one readout circuit RE1 (see FIG. 4).

The optical filter 4 includes, for example, a pigment that applies a color to a resin material. More specifically, as the resin, for example, an organic resin material such as a phthalocyanine derivative may be practically used.

### (6) Configuration of Optical Lens 5

As illustrated in FIG. 1, an optical lens 5 is disposed on an opposite side of the optical filter 4 to the first photoelectric conversion element 11. Although not illustrated, the optical lens 5 is formed in a circular shape for each of the first photoelectric conversion elements 11 in a plan view. Further, the optical lens 5 is curved toward the entering side of the entering light L when viewed in the arrow Y direction (hereinafter, simply described as "in a side view"), and is formed in a curved shape to collect the entering light L.

That is, the optical lens 5 is what is called an on-chip lens, and is integrally formed over multiple first photoelectric conversion elements 11. The optical lens 5 includes, for example, a transparent resin material.

### (7) Configuration of Second Base 20 and Second Photoelectric Conversion Element 21

As illustrated in FIG. 1, the second base 20 includes the second semiconductor substrate 22, a second wiring layer 23, and an insulator 24. The second wiring layer 23 is disposed on a surface 22B of the second semiconductor substrate 22 opposite to the arrow Z direction. The insulator 24 is disposed on a surface 22A of the second semiconductor substrate 22 on the arrow Z direction side. The first base 10 is stacked on the surface 22A of the second semiconductor substrate 22 with the insulator 24 interposed therebetween.

In the first embodiment, a material similar to that of the first semiconductor substrate 12 is used for the second semiconductor substrate 22. That is, here, the second semiconductor substrate 22 is a single crystal Si substrate.

As illustrated in FIGs. 1 and 3, the second photoelectric conversion element 21 overlaps the first photoelectric conversion element 11 and is disposed in the second semiconductor substrate 22 of the second base 20, in the region of the pixel 2. That is, the first photoelectric conversion element 11 and the second photoelectric conversion element 21 are stacked in order in the entering direction of the entering light L. Further, in other words, the first photoelectric conversion element 11 and the second photoelectric conversion element 21 are stacked vertically in the arrow Z direction.

Although the detailed structure and the description thereof are omitted, in the first embodiment, the second photoelectric conversion element 21 includes a SPAD. That is, the second photoelectric conversion element 21 includes an anode region including a p-type semiconductor region in the second semiconductor substrate 22 and a cathode region including an n-type semiconductor region in the second semiconductor substrate 22.

One second photoelectric conversion element 21 is disposed for one pixel 2. As illustrated in FIG. 3, the second photoelectric conversion element 21 is disposed at a middle part of the pixel 2. In a plan view, a plan shape of the second photoelectric conversion element 21 is formed in a rectangular shape that is a similar shape to the plan shape of the pixel 2.

In addition, the light blocker 6 is disposed along and around a side surface of the second photoelectric conversion element 21. The light blocker 6 is so disposed as to overlap a position corresponding to a space between the pixels 2 in a plan view. A plan shape of the light blocker 6 is formed in a lattice shape. The light blocker 6 electrically and optically isolates the second photoelectric conversion elements 21, from each other, that are adjacent to each other in each of the arrow X direction and the arrow Y direction.

The structure of the light blocker 6 will be described later.

In the second wiring layer 23, multiple layers of wirings 231 and a plug wiring 232 that electrically couples the element and the wiring 231 are disposed. Here, the element is the second photoelectric conversion element 21.

For the wiring 231, a wiring material such as Cu is used, for example. For the plug wiring 232, a wiring material such as W is used, for example.

Each of the wiring 231 and the plug wiring 232 is embedded in an insulating layer 235. In actuality, the insulating layer 235 is formed by stacking multiple layers of insulating films. As the insulating films, for example, SiO₂ is used.

The insulator 24 is used as a protective layer that joins the second semiconductor substrate 22 of the second base 20 and the first wiring layer 13 of the first base 10. For example, SiO₂ is used for the insulator 24.

### (8) Configuration of Light Blocker 6

As illustrated in FIGs. 1 and 3, the light blocker 6 is disposed along and around the side surface of the second photoelectric conversion element 21 as described above, when viewed from the entering side of the entering light L (in a plan view). Further, the light blocker 6 is configured to extend from the surface of the second base 20 on the entering side of the entering light L through at least the second semiconductor substrate 22 in the thickness direction.

More specifically, in the first embodiment, the second base 20 includes the insulator 24 on the surface 22A of the second semiconductor substrate 22 on the first base 10 side. The light blocker 6 extends from a surface 24A of the insulator 24 on the first base 10 side through the second semiconductor substrate 22. That is, a position of an end face 6A of the light blocker 6 in the arrow Z direction coincides with a position of the surface 24A of the insulator 24.

In addition, the second base 20 includes the second wiring layer 23 on the surface 22B of the second semiconductor substrate 22 on the third base 30 side. The light blocker 6 is disposed to extend to reach the wiring 231 of the second wiring layer 23. That is, a position of an end face 6B of the light blocker 6 opposite to the arrow Z direction coincides with a position of a surface of the wiring 231 in the arrow Z direction. In other words, the end face 6B of the light blocker 6 is in contact with the wiring 231.

The light blocker 6 has a groove 61 and includes a buried member 62. The buried member 62 is buried in the groove 61 and has a light blocking property.

The groove 61 is formed from the surface 24A of the insulator 24 of the second base 20 through the insulator 24 and the second semiconductor substrate 22 to a depth reaching the wiring 231 of the second wiring layer 23.

In the first embodiment, the buried member 62 includes a first buried member 621 and a second buried member 622.

The first buried member 621 is disposed along an inner wall of the groove 61. For the first buried member 621, for example, a barrier metal that is to be buried is used. As the barrier metal that is to be buried, for example, a metal material such as W or TiW is used. In addition, for the first buried member 621, an insulating material such as SiO₂ may be used as an insulator that is to be buried.

The second buried member 622 is buried with the first buried member 621 interposed between the inner wall of the groove 61 and the second buried member 622. For the second buried member 622, a material having a light blocking property or a material having an excellent light reflection characteristic is used. Specifically, the second buried member 622 includes one or more metal materials selected from Cu, W, Al, Ag, Ta, and Co, or an alloy material in which two or more thereof are combined.

### (9) Configuration of Third Base 30 and Circuit 31

As illustrated in FIG. 1, the third base 30 includes the third semiconductor substrate 32 and a third wiring layer 33. The third wiring layer 33 is disposed on a surface 32A of the third semiconductor substrate 32 in the arrow Z direction. The third semiconductor substrate 32 has a surface 32B opposite to the arrow Z direction. The second base 20 is stacked on the surface 32A of the third semiconductor substrate 32 with the third wiring layer 33 interposed therebetween.

In the first embodiment, a material similar to that of the first semiconductor substrate 12 is used for the third semiconductor substrate 32. That is, here, the third semiconductor substrate 32 is a single crystal Si substrate.

The circuit 31 is disposed on the surface 32A of the third semiconductor substrate 32. Although the detailed structure and the description thereof are omitted, a semiconductor element such as a transistor Tr configuring the first readout circuit RE1, the second readout circuit RE2, or both is disposed in the circuit 31. The first readout circuit RE1 is electrically coupled to the first photoelectric conversion element 11. The second readout circuit RE2 is electrically coupled to the second photoelectric conversion element 21.

At least multiple layers of wirings 331 are disposed in the third wiring layer 33. The multiple layers of wirings 331 electrically couple elements and the like. Here, the elements are semiconductor elements that form the circuit 31.

For the wirings 331, a wiring material such as Cu is used, for example. The wirings 331 are embedded in an insulating layer 335. In actuality, the insulating layer 335 is formed by stacking multiple layers of insulating films. As the insulating films, for example, SiO₂ is used.

The wiring 331 of the uppermost layer on the second base 20 side in the third wiring layer 33 and the wiring 231 of the uppermost layer on the third base 30 side in the second wiring layer 23 are each used as a terminal. These terminals are electrically coupled to each other and mechanically bonded to each other. Because, for example, Cu is used for each of the wiring 231 and the wiring 331 here, the wiring 231 and the wiring 331 are bonded to each other by Cu-Cu bonding.

### [Manufacturing Method of Photodetector 1]

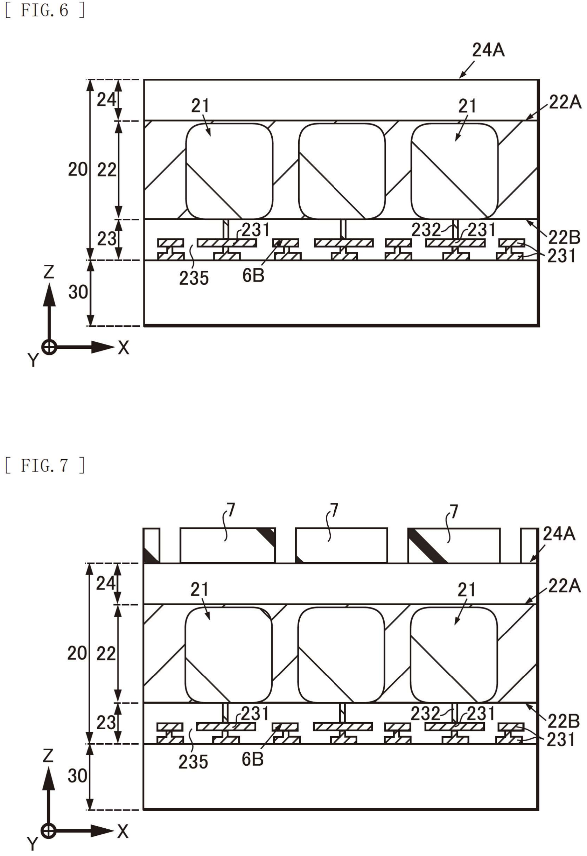

Next, with reference to FIGs. 6 to 11, a manufacturing method of the above-described photodetector 1 will be described. FIGs. 6 to 11 illustrate an example of a series of process cross-sections describing the manufacturing method of the photodetector 1 according to the first embodiment.

First, as illustrated in FIG. 6, the second base 20 is laminated on the third base 30. As illustrated in FIG. 1 described above, the third base 30 includes the third semiconductor substrate 32 and the third wiring layer 33; however, the third base 30 is illustrated in a simple manner here.

The second base 20 includes the second semiconductor substrate 22 and the second wiring layer 23. The second photoelectric conversion element 21 is formed in the second semiconductor substrate 22. In addition, the wiring 231, the insulating layer 235, and the like are formed in the second wiring layer 23.

In the second base 20, the insulator 24 is formed on the surface 22A of the second semiconductor substrate 22 (see FIG. 7). When the insulator 24 is formed, the second base 20 including the second semiconductor substrate 22, the second wiring layer 23, and the insulator 24 is formed.

As illustrated in FIG. 7, a mask 7 is formed on the insulator 24. The mask 7 is an etching mask having an opening in a formation region of the light blocker 6 (see FIGs. 1 and 3). For example, a photoresist film is used for the mask 7.

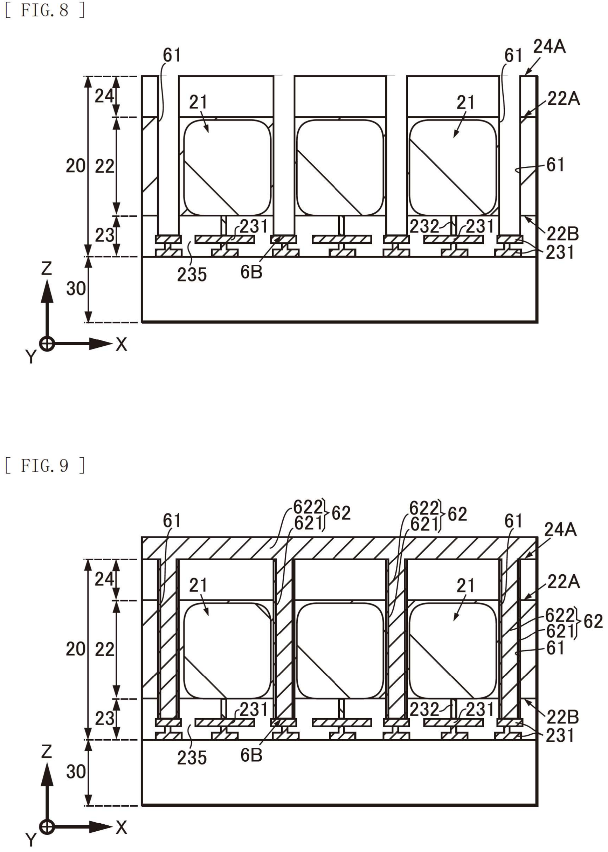

As illustrated in FIG. 8, an etching process is performed using the mask 7, and the groove 61 is formed in the second base 20. The groove 61 is formed from the surface 24A of the insulator 24 through the insulator 24 and the second semiconductor substrate 22 to a depth reaching the wiring 231 of the second wiring layer 23. In the etching process, an anisotropic etching method such as an RIE (Reactive Ion Etching) method is used. In addition, here, the wiring 231 is used as an etching stopper layer to control the depth of the groove 61.

As illustrated in FIG. 9, the buried member 62 is buried in the groove 61. Here, the buried member 62 includes the first buried member 621 and the second buried member 622. That is, first, the first buried member 621 is formed along the inner wall of the groove 61, and thereafter, the second buried member 622 is formed in the groove 61 with the first buried member 621 interposed therebetween.

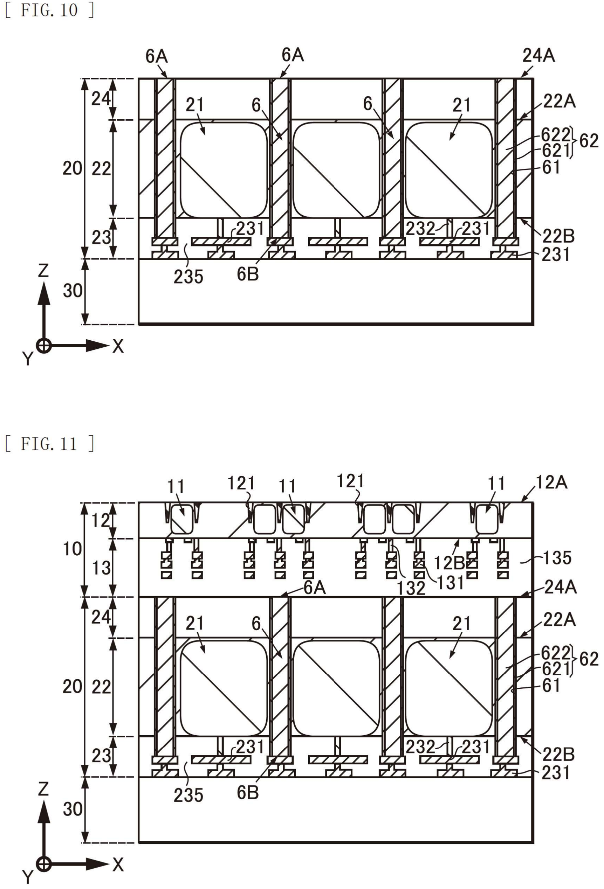

As illustrated in FIG. 10, the unnecessary buried member 62 formed on the surface 24A of the insulator 24 is removed. In the removal, for example, a CMP (Chemical Mechanical Polishing) method, an etch-back method, or the like is used.

When the unnecessary buried member 62 is removed, the light blocker 6 including the groove 61 and the buried member 62 is formed. The position of the end face 6A of the light blocker 6 in the arrow Z direction coincides with the position of the surface 24A of the insulator 24.

As illustrated in FIG. 11, the first base 10 is stacked in the arrow Z direction of the second base 20. Although a detailed description is omitted, as illustrated in FIG. 1 described above, the first base 10 includes the first semiconductor substrate 12 including the first photoelectric conversion element 11, and the first wiring layer 13 on the second base 20 side of the first semiconductor substrate 12.

As illustrated in FIG. 1 described above, the optical filter 4 is formed on the first photoelectric conversion element 11 in the first base 10, and the optical lens 5 is formed on the optical filter 4.

Upon completion of the series of processes, the photodetector 1 illustrated in FIG. 1 described above is completed.

### [Working and Effects]

As described above, the photodetector 1 according to the first embodiment includes the first base 10 and the second base 20 as illustrated in FIGs. 1 to 3.

The first base 10 includes the first semiconductor substrate 12 in which the first photoelectric conversion element 11 is disposed. The first photoelectric conversion element 11 converts the entering light L that has entered, into electric charge. The second base 20 is disposed on an opposite side of the first base 10 to the entering side of the entering light L, and includes the second semiconductor substrate 22 in which the second photoelectric conversion element 21 is disposed. The second photoelectric conversion element 21 converts the entering light L that has entered, into electric charge.

The photodetector 1 further includes the light blocker 6. The light blocker 6 is disposed, as viewed from the entering side of the entering light L, along and around the side surface of the second photoelectric conversion element 21. The light blocker 6 extends from the surface 24A (of the insulator 24) of the second base 20 on the entering side of the entering light L through at least the second semiconductor substrate 22 in the thickness direction. The light blocker 6 blocks light from the second photoelectric conversion element 21.

In the photodetector 1 having such a configuration, the light blocker 6 is disposed around the side surface of the second photoelectric conversion element 21, and the light blocker 6 is formed from the surface 24A of the second base 20 through the second semiconductor substrate 22. That is, in the second base 20, because the light blocker 6 is disposed to extend from a region around the side surface of the second photoelectric conversion element 21 to the first base 10, a path formed between the second photoelectric conversion elements 21 adjacent to each other and causing light leakage Le of light generated from the second photoelectric conversion element 21 is blocked. The light generated from the second photoelectric conversion element 21 is also allowed to travel to the first base 10 side, and is also reflected on the first base 10 side. The light blocker 6 makes it possible to generally reduce most of the light leakage Le between the second photoelectric conversion elements 21 adjacent to each other.

Therefore, it is possible to effectively suppress or prevent color mixing between the second photoelectric conversion elements 21 disposed to be adjacent to each other.

Further, in the photodetector 1, as illustrated in FIGs. 1 and 3, the first base 10 includes the first wiring layer 13 on the second base 20 side of the first semiconductor substrate 12. The second base 20 includes the insulator 24 on the first base 10 side of the second semiconductor substrate 22. Further, the light blocker 6 extends from the surface 24A of the insulator 24 on the first base 10 side through the second semiconductor substrate 22.

Therefore, in the second base 20, because the light blocker 6 is disposed from the second semiconductor substrate 22 to the surface 24A of the insulator 24, it is possible to effectively reduce the path of the light leakage Le between the second photoelectric conversion elements 21 adjacent to each other. Accordingly, it is possible to effectively suppress or prevent the color mixing between the second photoelectric conversion elements 21 disposed to be adjacent to each other.

In addition, in the photodetector 1, as illustrated in FIG. 1, the second base 20 includes the second wiring layer 23 on an opposite side of the second semiconductor substrate 22 to the first base 10. The second wiring layer 23 includes the wiring 231. Further, the light blocker 6 is disposed to extend to reach the wiring 231 of the second wiring layer 23.

Therefore, in the second base 20, because the light blocker 6 is disposed from the second semiconductor substrate 22 to the wiring 231 of the second wiring layer 23, it is possible to effectively reduce the path of the light leakage Le between the second photoelectric conversion elements 21 adjacent to each other on the second wiring layer 23 side. Accordingly, it is possible to effectively suppress or prevent the color mixing between the second photoelectric conversion elements 21 disposed to be adjacent to each other.

In addition, in the photodetector 1, as illustrated in FIGs. 1 and 3, the second photoelectric conversion element 21 is a SPAD that multiplies a carrier generated by a photon of the entering light L. Therefore, it is possible to effectively suppress or prevent leakage of carriers multiplied by the SPAD between the second photoelectric conversion elements 21 adjacent to each other.

Here, in the photodetector 1, the first photoelectric conversion element 11 and the second photoelectric conversion element 21 are coaxially disposed with respect to the optical axis of the entering light L. Therefore, because a circuit configuration that allows the two optical axes to coincide with each other is not required, it is possible to simplify the circuit configuration of the first readout circuit RE1 and the second readout circuit RE2 and subsequent circuits.

In addition, as illustrated in FIG. 1, the photodetector 1 includes the third base 30. The third base 30 is disposed on an opposite side of the second base 20 to the first base 10 and includes the third semiconductor substrate 32 on which the circuit 31 is mounted. The circuit 31 is electrically coupled to the first photoelectric conversion element 11, the second photoelectric conversion element 21, or both.

Therefore, it is possible to obtain the photodetector 1 that includes the first photoelectric conversion element 11, the second photoelectric conversion element 21, and the circuit 31, and makes it possible to effectively suppress or prevent the color mixing between the second photoelectric conversion elements 21 disposed to be adjacent to each other.

### <2. Second Embodiment>

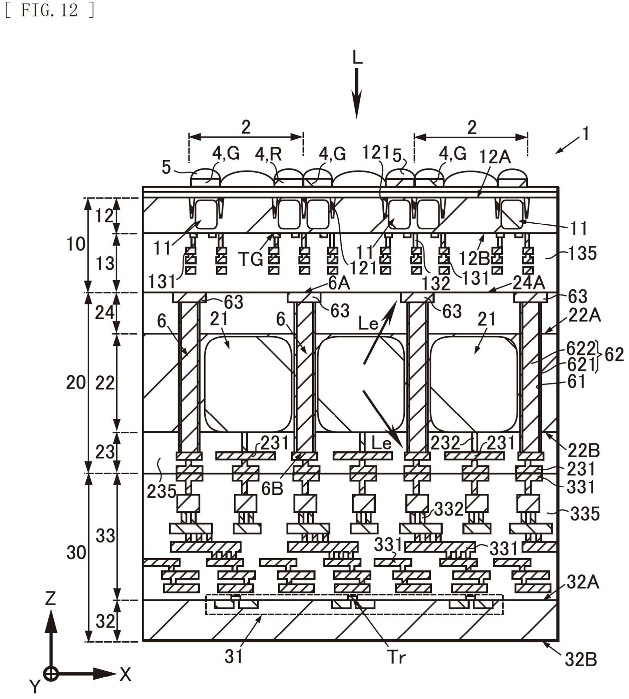

The photodetector 1 according to the second embodiment of the present disclosure will be described with reference to FIG. 12.

It is to be noted that in the second embodiment and subsequent embodiments, components that are the same as or substantially the same as the components of the photodetector 1 according to the first embodiment are denoted by the same reference signs, and redundant descriptions will be omitted.

### [Configuration of Photodetector 1]

FIG. 12 illustrates an example of a vertical cross-sectional configuration corresponding to the multiple pixels 2 of the photodetector 1 according to the second embodiment.

As illustrated in FIG. 12, the photodetector 1 includes a second terminal 63 in the light blocker 6. The second terminal 63 is disposed on the surface 24A of the insulator 24 in the second base 20, and is coupled to the buried member 62 of the light blocker 6.

In the second embodiment, the second terminal 63 includes the same material as the second buried member 622 of the buried member 62. Further, the second terminal 63 may be different from the second buried member 622, but includes one or more materials selected from the materials exemplified for the second buried member 622. In other words, the second terminal 63 is formed as a part of the light blocker 6, and the light blocker 6 is configured to include the second terminal 63. That is, a surface of the second terminal 63 on the first base 10 side is formed as the end face 6A of the light blocker 6. The position of the end face 6A coincides with the position of the surface 24A of the insulator 24.

In addition, the second terminal 63 has a width dimension greater than a groove width dimension of the groove 61 of the light blocker 6 in the same direction. Here, the second terminal 63 is formed in a shape protruding in a horizontal direction from the groove 61, in a side view.

Components other than the above-described components are the same as or substantially the same as the components of the photodetector 1 according to the first embodiment described above, and the descriptions of the same components are therefore omitted.

### [Working and Effects]

As described above, the photodetector 1 according to the second embodiment makes it possible to achieve working and effects similar to those achieved by the photodetector 1 according to the first embodiment.

In addition, in the photodetector 1, as illustrated in FIG. 12, the light blocker 6 includes the second terminal 63. The second terminal 63 is disposed on the surface (24A) side in the second base 20, and is coupled to the buried member 62. In addition, the width dimension of the second terminal 63 is greater than the width dimension of the groove 61 of the light blocker 6 in the same direction.

Therefore, the path formed between the second photoelectric conversion elements 21 adjacent to each other and causing the light leakage Le of light generated from the second photoelectric conversion element 21 to the first base 10 side is blocked. The second terminal 63 of the light blocker 6 makes it possible to improve a reduction rate of the light leakage Le between the second photoelectric conversion elements 21 adjacent to each other.

Accordingly, it is possible to more effectively suppress or prevent the color mixing between the second photoelectric conversion elements 21 disposed to be adjacent to each other.

In the present technology, the width dimension of the second terminal 63 may be smaller than the width dimension of the groove 61 of the light blocker 6 in the same direction.

### <3. Third Embodiment>

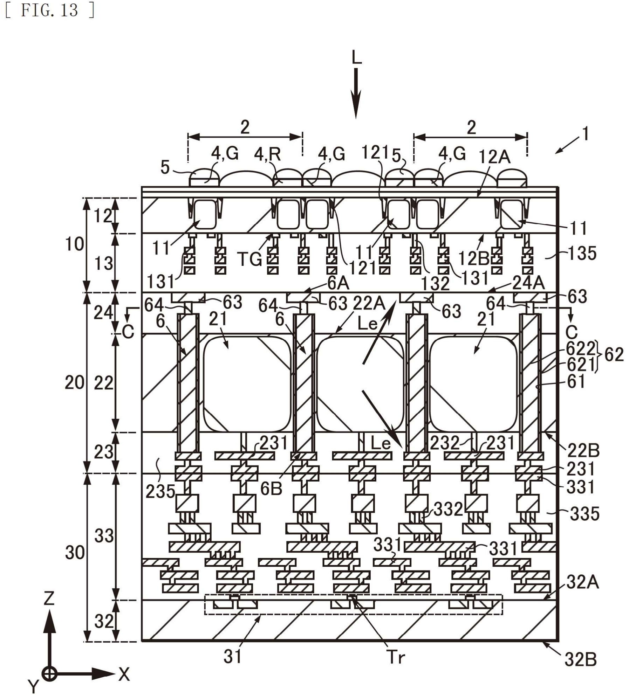

The photodetector 1 according to the third embodiment of the present disclosure will be described with reference to FIGs. 13 to 15.

### [Configuration of Photodetector 1]

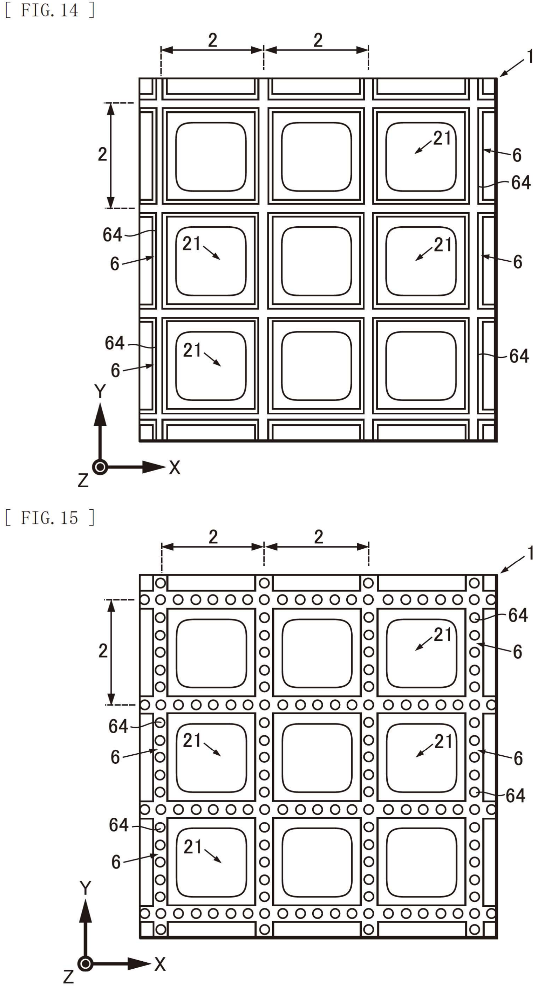

FIG. 13 illustrates an example of a vertical cross-sectional configuration corresponding to the multiple pixels 2 of the photodetector 1 according to the third embodiment. FIG. 14 illustrates an example of a plan configuration of the second photoelectric conversion element 21 and the light blocker 6 of the photodetector 1.

As illustrated in FIGs. 13 and 14, in the photodetector 1, the second terminal 63 of the light blocker 6 in the photodetector 1 according to the second embodiment is coupled to the buried member 62 with a plug electrical conductor 64 interposed therebetween. The plug electrical conductor 64 is continuously disposed around the side surface of the second photoelectric conversion element 21.

In addition, the plug electrical conductor 64 includes a material having at least a light blocking property, as with the second buried member 622 of the buried member 62.

Components other than the above-described components are the same as or substantially the same as the components of the photodetector 1 according to the second embodiment described above, and the descriptions of the same components are therefore omitted.

### [Working and Effects]

As described above, the photodetector 1 according to the third embodiment makes it possible to achieve working and effects similar to those achieved by the photodetector 1 according to the second embodiment.

### [Modification Example]

FIG. 14 illustrates an example of a plan configuration of the second photoelectric conversion element 21 and the light blocker 6 of the photodetector 1 according to a modification example of the third embodiment.

In the photodetector 1 according to the modification example, as illustrated in FIG. 14, the plug electrical conductors 64 are disposed discontinuously at equal intervals around the side surface of the second photoelectric conversion element 21. In other words, the plug electrical conductor 64 is formed in a dot shape in a plan view.

Components other than the above-described components are the same as or substantially the same as the components of the photodetector 1 according to the third embodiment described above, and the descriptions of the same components are therefore omitted.

### [Working and Effects]

As described above, the photodetector 1 according to the modification example makes it possible to achieve working and effects similar to those achieved by the photodetector 1 according to the third embodiment.

### <4. Fourth Embodiment>

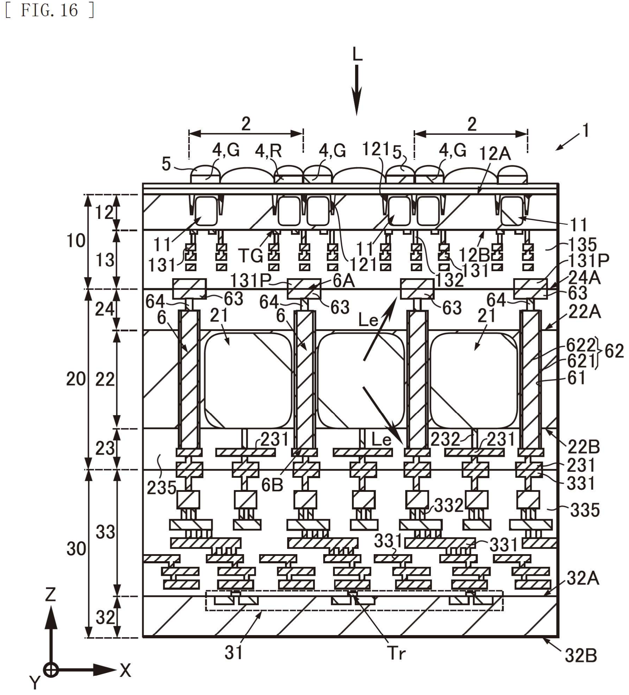

The photodetector 1 according to the fourth embodiment of the present disclosure will be described with reference to FIG. 16.

### [Configuration of Photodetector 1]

FIG. 16 illustrates an example of a vertical cross-sectional configuration corresponding to the multiple pixels 2 of the photodetector 1 according to the fourth embodiment.

As illustrated in FIG. 16, in the photodetector 1, the first base 10 in the photodetector 1 according to the third embodiment includes the first wiring layer 13 that includes a first terminal 131P, on the second base 20 side of the first semiconductor substrate 12. The first terminal 131P is formed by the wiring 131 of the uppermost layer on the second base 20 side of the first wiring layer 13.

The second terminal 63 of the light blocker 6 of the second base 20 is electrically coupled to and mechanically bonded to the first terminal 131P at a stacking interface (a bonding interface) between the first base 10 and the second base 20.

When each of the second terminal 63 and the first terminal 131P includes, for example, Cu, the second terminal 63 and the first terminal 131P are bonded to each other by Cu-Cu bonding.

When the buried member 62 of the light blocker 6 includes an electrically conductive material, the light blocker 6 is usable as a through wiring. That is, it is possible to supply a signal, a power supply, or the like between the first base 10 and the third base 30 through the light blocker 6.

Components other than the above-described components are the same as or substantially the same as the components of the photodetector 1 according to the third embodiment described above, and the descriptions of the same components are therefore omitted.

### [Working and Effects]

As described above, the photodetector 1 according to the fourth embodiment makes it possible to achieve working and effects similar to those achieved by the photodetector 1 according to the third embodiment.

### <5. Fifth Embodiment>

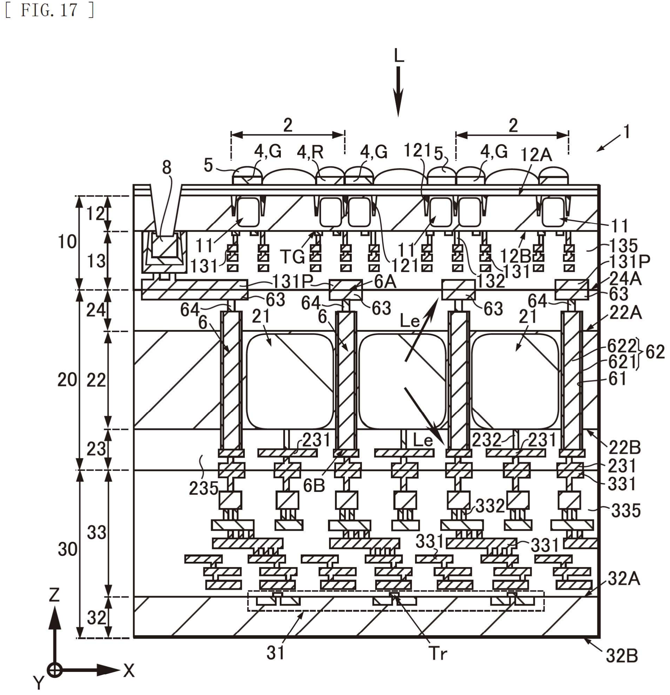

The photodetector 1 according to the fifth embodiment of the present disclosure will be described with reference to FIG. 17.

### [Configuration of Photodetector 1]

FIG. 17 illustrates an example of a vertical cross-sectional configuration corresponding to the multiple pixels 2 of the photodetector 1 according to the fifth embodiment.

As illustrated in FIG. 17, in the photodetector 1, the second terminal 63 of the light blocker 6 in the photodetector 1 according to the fourth embodiment has electrical conductivity, and a part of the second terminal 63 is disposed to extend as a lead-out wiring. Here, the second terminal 63 is disposed to extend as a lead-out wiring from an end part of a pixel region in which the multiple pixels 2 are arranged to a peripheral region of the photodetector 1. In addition, as with the second terminal 63, the first terminal 131P is provided to extend as a lead-out wiring.

The lead-out wiring is electrically coupled to an external terminal 8 disposed in the first wiring layer 13 of the first base 10 in the peripheral region of the photodetector 1. One end of a bonding wire is electrically coupled to the external terminal 8. Another end of the bonding wire is electrically coupled to an external device, a wiring substrate, or the like, which is not illustrated, of the photodetector 1.

Alternatively, the lead-out wiring may be configured to be electrically coupled to an external terminal disposed on the surface 32B of the third semiconductor substrate 32 of the third base 30. For the electrical coupling between the lead-out wiring and the external terminal, a through wiring having a structure similar to that of the light blocker 6 may be used. Further, the external terminal is electrically coupled to an external device, a wiring substrate, or the like, which is not illustrated, through a micro-bump electrode.

Components other than the above-described components are the same as or substantially the same as the components of the photodetector 1 according to the fourth embodiment described above, and the descriptions of the same components are therefore omitted.

### [Working and Effects]

As described above, the photodetector 1 according to the fifth embodiment makes it possible to achieve working and effects similar to those achieved by the photodetector 1 according to the fourth embodiment.

### <6. Sixth Embodiment>

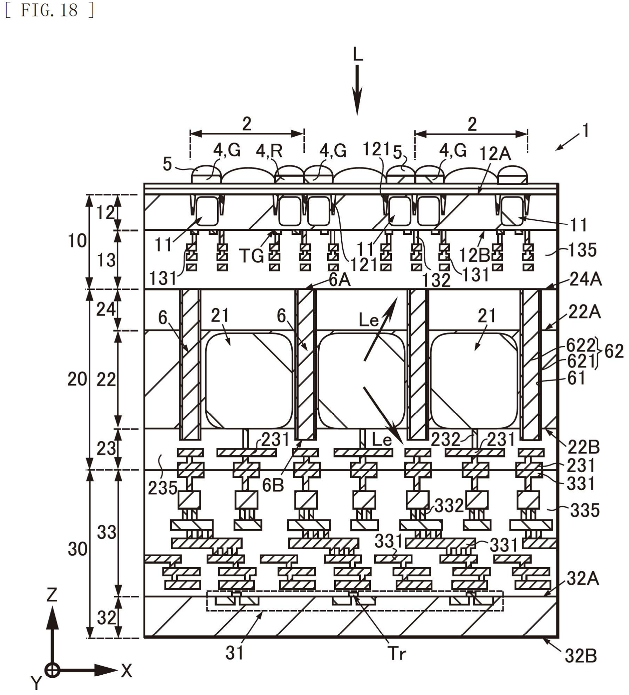

The photodetector 1 according to the sixth embodiment of the present disclosure will be described with reference to FIG. 18.

### [Configuration of Photodetector 1]

FIG. 18 illustrates an example of a vertical cross-sectional configuration corresponding to the multiple pixels 2 of the photodetector 1 according to the sixth embodiment.

As illustrated in FIG. 18, in the photodetector 1, the light blocker 6 in the photodetector 1 according to the first embodiment is disposed to extend to a point before the wiring 231 of the second wiring layer 23 of the second base 20. Although not illustrated in detail, an insulating film of the insulating layer 235 is interposed between the end face 6B of the light blocker 6 and the wiring 231.

Components other than the above-described components are the same as or substantially the same as the components of the photodetector 1 according to the first embodiment described above, and the descriptions of the same components are therefore omitted.

### [Working and Effects]

As described above, the photodetector 1 according to the sixth embodiment makes it possible to achieve working and effects similar to those achieved by the photodetector 1 according to the first embodiment.

### <7. Seventh Embodiment>

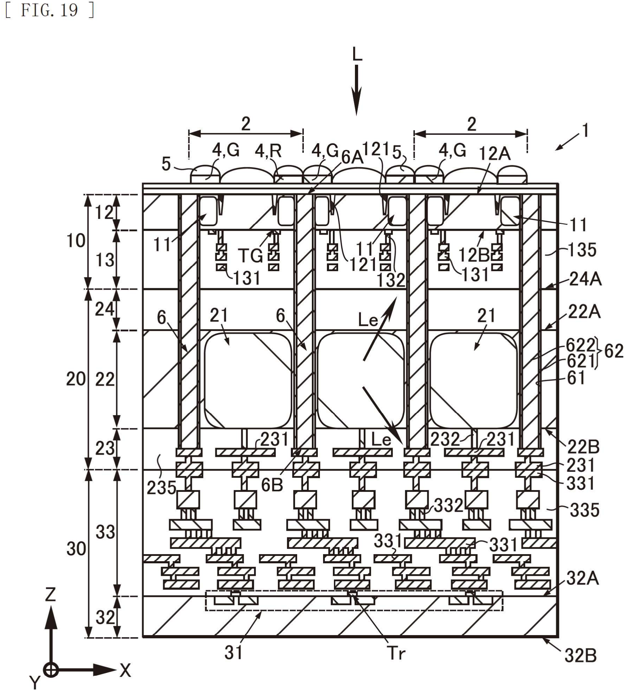

The photodetector 1 according to a seventh embodiment of the present disclosure will be described with reference to FIG. 19.

### [Configuration of Photodetector 1]

FIG. 19 illustrates an example of a vertical cross-sectional configuration corresponding to the multiple pixels 2 of the photodetector 1 according to the seventh embodiment.

As illustrated in FIG. 19, in the photodetector 1, the light blocker 6 in the photodetector 1 according to the first embodiment is provided to extend from the second base 20 to the first base 10. That is, the light blocker 6 is so disposed as to extend from the surface 12A of the first semiconductor substrate 12 of the first base 10 through the first semiconductor substrate 12, the first wiring layer 13, the insulator 24, and the second semiconductor substrate 22 and to reach the wiring 231 of the second wiring layer 23.

Components other than the above-described components are the same as or substantially the same as the components of the photodetector 1 according to the first embodiment described above, and the descriptions of the same components are therefore omitted.

### [Working and Effects]

As described above, the photodetector 1 according to the seventh embodiment makes it possible to achieve working and effects similar to those achieved by the photodetector 1 according to the first embodiment.

Further, in the photodetector 1, as illustrated in FIG. 19, because the light blocker 6 is disposed across the first base 10 and the second base 20, it is possible to even more effectively suppress or prevent color mixing between the first photoelectric conversion elements 11 disposed to be adjacent to each other and the second photoelectric conversion elements 21 disposed to be adjacent to each other.

### <8. Example of Practical Application to Mobile Body>

The technique according to the present disclosure (the present technology) is applicable to various products. For example, the technique according to the present disclosure may be achieved as an apparatus to be mounted to a mobile body of any kind. Examples of the mobile body include an automobile, an electric vehicle, a hybrid electric vehicle, a motorcycle, a bicycle, a personal mobility device, an airplane, a drone, a vessel, and a robot.

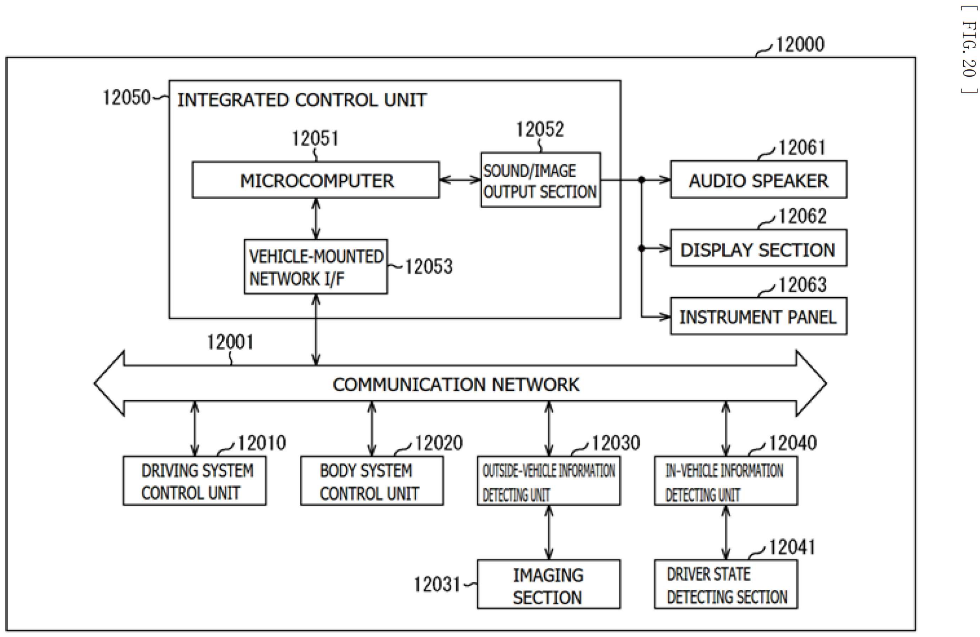

FIG. 20 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 20, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle- mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 20, an audio speaker 12061, a display section 12062, and an instrument panel 12063 are illustrated as the output device. The display section 12062 may, for example, include at least one of an on-board display and a head-up display.

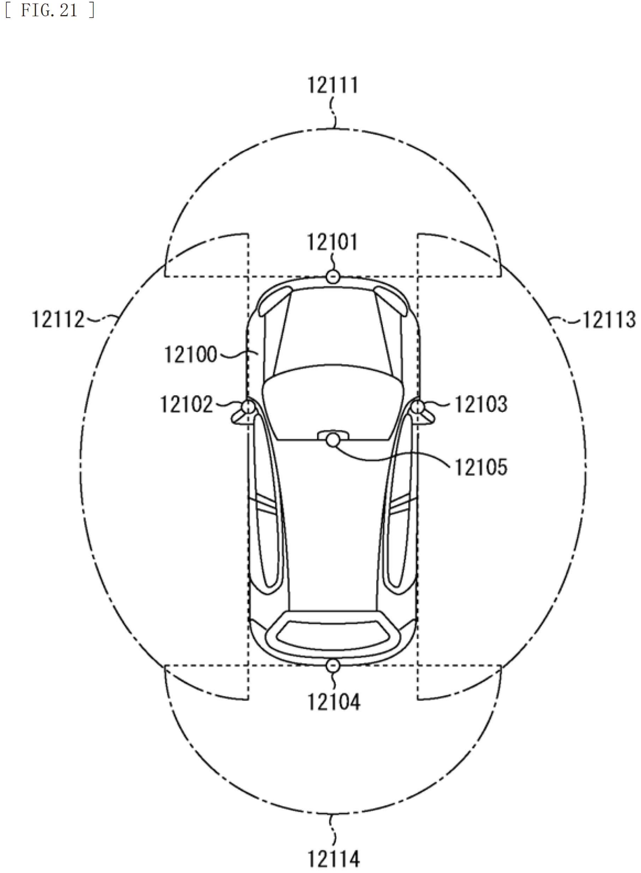

FIG. 21 is a diagram depicting an example of the installation position of the imaging section 12031.

In FIG. 21, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 21 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The description has been given above of one example of the vehicle control system to which the technique according to the present disclosure may be applied. The technique according to the present disclosure may be applied to the imaging section 12031 in the configuration described above. The application of the technique according to the present disclosure to the imaging section 12031 makes it possible to achieve the imaging section 12031 that makes it possible to effectively suppress or prevent color mixing between photoelectric conversion elements adjacent to each other.

### <9. Other Embodiments>

The present technology is not limited to the above-described embodiments, and various modifications may be made without departing from the gist thereof.

For example, among the photodetectors according to the first to the seventh embodiments described above, the photodetectors according to two or more embodiments may be combined.

A photodetector according to a first embodiment of the present disclosure includes a first base and a second base. The first base includes a first semiconductor substrate in which a first photoelectric conversion element is disposed. The first photoelectric conversion element converts entering light into electric charge. The second base is disposed on an opposite side of the first base 10 to a light entering side and includes a second semiconductor substrate in which a second photoelectric conversion element is disposed. The second photoelectric conversion element converts entering light into electric charge.

The photodetector further includes a light blocker. The light blocker is disposed, as viewed from the light entering side, along and around a side surface of the second photoelectric conversion element. The light blocker extends from a surface of the second base on the light entering side through at least the second semiconductor substrate in a thickness direction. The light blocker blocks light from the second photoelectric conversion element.

The photodetector having such a configuration makes it possible to effectively suppress or prevent color mixing between the second photoelectric conversion elements disposed to be adjacent to each other.

In a photodetector according to a second embodiment of the present disclosure, the first photoelectric conversion element in the photodetector according to the first embodiment includes a photodiode. In addition, the second photoelectric conversion element includes an avalanche diode that multiplies a carrier generated by a photon of entering light.

The photodetector having such a configuration makes it possible to effectively suppress or prevent, in particular, leakage of carriers multiplied by the avalanche diode between the second photoelectric conversion elements adjacent to each other.

The photodetector according to a third embodiment of the present disclosure further includes a third base in the photodetector according to the first embodiment or the second embodiment. The third base is disposed on an opposite side of the second base to the first base and includes a third semiconductor substrate on which a circuit is mounted. The circuit is electrically coupled to the first photoelectric conversion element, the second photoelectric conversion element, or both.

It is possible to obtain a photodetector that includes the first photoelectric conversion element, the second photoelectric conversion element, and the circuit, and makes it possible to effectively suppress or prevent the color mixing between the second photoelectric conversion elements disposed to be adjacent to each other.

### <Configuration of Present Technology>

The present technology has any of the following configurations. According to the present technology having any of the following configurations, it is possible to effectively suppress or prevent color mixing between photoelectric conversion elements disposed to be adjacent to each other in a photodetector.
(1) A photodetector including:
   a first base including a first semiconductor substrate in which a first photoelectric conversion element is disposed, the first photoelectric conversion element converting entering light into electric charge;
   a second base disposed on an opposite side of the first base to a light entering side and including a second semiconductor substrate in which a second photoelectric conversion element is disposed, the second photoelectric conversion element converting entering light into electric charge; and
   a light blocker disposed, as viewed from the light entering side, along and around a side surface of the second photoelectric conversion element, the light blocker extending from a surface of the second base on the light entering side through at least the second semiconductor substrate in a thickness direction, the light blocker blocking light from the second photoelectric conversion element.
(2) The photodetector according to (1) described above, in which
   the first base includes a first wiring layer on the first semiconductor substrate, on a side of the second base,
   the second base includes an insulator on the second semiconductor substrate, on a side of the first base, and
   the light blocker extends from a surface of the insulator on the side of the first base through the second semiconductor substrate.
(3) The photodetector according to (1) or (2) described above, in which
   the second base includes a second wiring layer on an opposite side of the second semiconductor substrate to the first base, the second wiring layer including a wiring, and
   the light blocker is disposed to extend to a point before the wiring of the second wiring layer.
(4) The photodetector according to (1) or (2) described above, in which
   the second base includes a second wiring layer on an opposite side of the second semiconductor substrate to the first base, the second wiring layer including a wiring, and
   the light blocker is disposed to extend to reach the wiring of the second wiring layer.
(5) The photodetector according to any one of (1) to (4) described above, in which
   the light blocker has a groove and includes a buried member,
   the groove being provided at least along a thickness direction of the second semiconductor substrate, and
   a buried member being buried in the groove and having a light blocking property.
(6) The photodetector according to (5) described above, in which
   the buried member includes
   a first buried member provided along an inner wall of the groove, and
   a second buried member buried in the groove with the first buried member interposed between the second buried member and the groove.
(7) The photodetector according to (6) described above, in which
   the first buried member includes a barrier metal that is to be buried or an insulator that is to be buried, and
   the second buried member includes one or more metals selected from Cu, W, Al, Ag, Ta, and Co, or an alloy in which two or more selected from Cu, W, Al, Ag, Ta, and Co are combined.
(8) The photodetector according to any one of (5) to (7) described above, in which the light blocker further includes a second terminal that is disposed on a side of the surface of the second base, and is coupled to the buried member.
(9) The photodetector according to (8) described above, in which the second terminal has a width dimension greater than a width dimension of the groove in same direction.
(10) The photodetector according to (8) or (9) described above, in which the second terminal has electrical conductivity, and a part of the second terminal is disposed to extend as a lead-out wiring.
(11) The photodetector according to any one of (8) to (10) described above, in which
   the first base includes a first wiring layer on the first semiconductor substrate, on a side of the second base, the first wiring layer including a first terminal, and
   the second terminal is joined to the first terminal.
(12) The photodetector according to any one of (8) to (11) described above, in which the second terminal is coupled to the buried member with a plug electrical conductor interposed between the second terminal and the buried member.
(13) The photodetector according to (12) described above, in which the plug electric conductor is disposed continuously around the side surface of the second photoelectric conversion element.
(14) The photodetector according to (12) described above, in which the plug electric conductor is disposed discontinuously around the side surface of the second photoelectric conversion element.
(15) The photodetector according to any one of (1) to (14) described above, in which
   the first photoelectric conversion element includes a photodiode, and
   the second photoelectric conversion element includes an avalanche diode that multiplies a carrier generated by a photon of entering light.
(16) The photodetector according to any one of (1) to (15) described above, further including a third base disposed on an opposite side of the second base to the first base and including a third semiconductor substrate on which a circuit is mounted, the circuit being electrically coupled to the first photoelectric conversion element, the second photoelectric conversion element, or both.

It should be understood by those skilled in the art that various modifications, combinations, subcombinations and alterations may occur depending on design requirements and other factors insofar as they are within the scope of the appended claims or the equivalents thereof.

## Claims

1. A photodetector comprising:
a first base including a first semiconductor substrate in which a first photoelectric conversion element is disposed, the first photoelectric conversion element converting entering light into electric charge;
a second base disposed on an opposite side of the first base to a light entering side and including a second semiconductor substrate in which a second photoelectric conversion element is disposed, the second photoelectric conversion element converting entering light into electric charge; and
a light blocker disposed, as viewed from the light entering side, along and around a side surface of the second photoelectric conversion element, the light blocker extending from a surface of the second base on the light entering side through at least the second semiconductor substrate in a thickness direction, the light blocker blocking light from the second photoelectric conversion element.

2. The photodetector according to claim 1, wherein
the first base includes a first wiring layer on the first semiconductor substrate, on a side of the second base,
the second base includes an insulator on the second semiconductor substrate, on a side of the first base, and
the light blocker extends from a surface of the insulator on the side of the first base through the second semiconductor substrate.

3. The photodetector according to claim 1, wherein
the second base includes a second wiring layer on an opposite side of the second semiconductor substrate to the first base, the second wiring layer including a wiring, and
the light blocker is disposed to extend to a point before the wiring of the second wiring layer.

4. The photodetector according to claim 1, wherein
the second base includes a second wiring layer on an opposite side of the second semiconductor substrate to the first base, the second wiring layer including a wiring, and
the light blocker is disposed to extend to reach the wiring of the second wiring layer.

5. The photodetector according to claim 1, wherein
the light blocker has a groove and includes a buried member,
the groove being provided at least along a thickness direction of the second semiconductor substrate,
the buried member being buried in the groove and having a light blocking property.

6. The photodetector according to claim 5, wherein
the buried member includes
a first buried member provided along an inner wall of the groove, and
a second buried member buried in the groove with the first buried member interposed between the second buried member and the groove.

7. The photodetector according to claim 6, wherein
the first buried member includes a barrier metal that is to be buried or an insulator that is to be buried, and
the second buried member includes one or more metals selected from Cu, W, Al, Ag, Ta, and Co, or an alloy in which two or more selected from Cu, W, Al, Ag, Ta, and Co are combined.

8. The photodetector according to claim 5, wherein the light blocker further includes a second terminal that is disposed on a side of the surface of the second base, and is coupled to the buried member.

9. The photodetector according to claim 8, wherein the second terminal has a width dimension greater than a width dimension of the groove in same direction.

10. The photodetector according to claim 8, wherein the second terminal has electrical conductivity, and a part of the second terminal is disposed to extend as a lead-out wiring.

11. The photodetector according to claim 8, wherein
the first base includes a first wiring layer on the first semiconductor substrate, on a side of the second base, the first wiring layer including a first terminal, and
the second terminal is joined to the first terminal.

12. The photodetector according to claim 8, wherein the second terminal is coupled to the buried member with a plug electrical conductor interposed between the second terminal and the buried member.

13. The photodetector according to claim 12, wherein the plug electric conductor is disposed continuously around the side surface of the second photoelectric conversion element.

14. The photodetector according to claim 12, wherein the plug electric conductor is disposed discontinuously around the side surface of the second photoelectric conversion element.

15. The photodetector according to claim 1, wherein
the first photoelectric conversion element comprises a photodiode, and
the second photoelectric conversion element comprises an avalanche diode that multiplies a carrier generated by a photon of entering light.

16. The photodetector according to claim 1, further comprising a third base disposed on an opposite side of the second base to the first base and including a third semiconductor substrate on which a circuit is mounted, the circuit being electrically coupled to the first photoelectric conversion element, the second photoelectric conversion element, or both.
